Europäisches Patentamt

European Patent Office

Office européen des brevets

(19)

(11) **EP 1 040 175 B1**

(12) **FASCICULE DE BREVET EUROPEEN**

(45) Date de publication et mention
de la délivrance du brevet:
**28.04.2004 Bulletin 2004/18**

(51) Int Cl.[7]: **C10G 9/20**, B01J 19/00,
C23C 16/30, F02B 77/04,
C23C 16/40, C23C 16/34

(21) Numéro de dépôt: **99970412.5**

(22) Date de dépôt: **07.10.1999**

(86) Numéro de dépôt international:
**PCT/FR1999/002403**

(87) Numéro de publication internationale:
**WO 2000/022068 (20.04.2000 Gazette 2000/16)**

(54) **REVETEMENTS ANTI-COKAGE**

ANTI-VERKOKUNGSBESCHICHTUNGEN

ANTI-COKING COATINGS

(84) Etats contractants désignés:
**AT BE CH CY DE DK ES FI FR GB GR IE IT LI LU
MC NL PT SE**

(30) Priorité: **09.10.1998 FR 9812687**

(43) Date de publication de la demande:
**04.10.2000 Bulletin 2000/40**

(73) Titulaires:
• **COMMISSARIAT A L'ENERGIE ATOMIQUE**
**75015 Paris (FR)**
• **Manoir industries**
**75008 Paris (FR)**

(72) Inventeurs:
• **PIET, Gérard**
**F-38830 Saint-Pierre D'Allevard (FR)**
• **SCHUSTER, Frédéric**
**F-38250 Lans-en-Vercors (FR)**

• **FLAHAUT, Dominique**
**76140 Le Petit Quevilly (FR)**
• **VERDIER, Gilles**
**F-76130 Mont-Saint Aignan (FR)**

(74) Mandataire: **Audier, Philippe André et al**
**Brevalex,**
**3, rue du Docteur Lancereaux**
**75008 Paris (FR)**

(56) Documents cités:
**EP-A- 0 540 084          GB-A- 2 104 054**

• **SAVALL C ET AL: "HYDROGEN AND
DEUTERIUM MIGRATION IN ANNEALED
PLASMA-DEPOSITED SILICON NITRIDE FILMS"
THIN SOLID FILMS, vol. 258, no. 1/02, 15 mars
1995 (1995-03-15), pages 1-4, XP000501860**

**Description**

**Domaine technique**

La présente invention a pour objet des revêtements anti-cokage pour prévenir le dépôt de coke sur des pièces en alliage réfractaire utilisées dans le domaine pétrolier.

Dans les raffineries de pétrole, les centrales thermiques, les installations de production de polymères, et autres, il existe de nombreux composants qui sont en contact avec des fluides hydrocarbonés chauds, à des températures auxquelles des produits de dégradation se forment dans les hydrocarbures et peuvent conduire à des dépôts de coke sur les composants.

Le coke a plusieurs origines :

- Il peut s'agir de coke "pyrolytique" qui est inhérent au procédé. Ainsi lors du vapocraquage d'hydrocarbures, les réactions chimiques ont pour origine le craquage des chaînes carbonées avec pour conséquence la création des gaz légers désirés (éthylène et propylène) et la formation de coke pyrolytique.
- Il peut s'agir de coke "catalytique" dû à la présence en grandes quantités d'éléments réputés pour favoriser le cokage comme le nickel et le fer, dans les composants en contact avec les hydrocarbures. Ces éléments (nickel et fer) induisent la catalyse hétérogène de différentes réactions chimiques engendrant la production de carbone solide se déposant sur les surfaces sous la forme de filaments et/ou de carbone amorphe.

Le coke est à l'origine des phénomènes de corrosion des composants, par exemple des tubes de four de pétrochimie. Il s'installe sur les parois des tubes, et de manière préférentielle, sur les parties les plus chaudes. Les différents problèmes liés au dépôt de coke sont les suivants :

1°) Une perte de transfert de chaleur de l'extérieur du tube vers l'intérieur car le coke agit comme un isolant thermique, ce qui nécessite un chauffage plus énergétique afin d'obtenir par exemple la température de vapocraquage désirée (environ 850°C). Il existe alors un risque d'endommagement de l'alliage réfractaire du tube et, au bout d'un certain temps, l'exploitant doit inévitablement réaliser une opération de décokage, c'est-à-dire éliminer ce coke en l'oxydant grâce à de la vapeur d'eau et/ou de l'air ;

2°) Une carburation des tubes. En effet, bien qu'une couche protectrice contenant du chrome se forme généralement à la surface du tube, cette dernière se fissure facilement à cause des contraintes de compression engendrées par une différence de maille métal/oxyde ainsi que par les conditions d'utilisation des tubes de vapocraquage (chocs thermiques dus au cycle de cokage/décokage).

Aussi, il est d'un grand intérêt de trouver le moyen de prévenir le dépôt de coke sur les surfaces en alliages réfractaires en contact avec des fluides hydrocarbonés chauds.

**Etat de la technique antérieure**

La technique la plus utilisée pour éviter ou freiner le dépôt de coke sur les surfaces métalliques est d'appliquer sur celles-ci un revêtement anti-cokage.

Ainsi, le document FR-A-2 662 704 [1] prévoit d'utiliser comme revêtement anti-cokage des oxydes, des carbures, des nitrures et/ou des siliciures tels que des siliciures de titane, de zirconium et de niobium, ce revêtement pouvant être appliqué par des procédés classiques tels que le dépôt chimique en phase vapeur (CVD) ou le dépôt chimique en phase vapeur assisté par plasma (PACVD). Dans ce document, on obtient de bons résultats sur une surface métallique en super alliage de nickel avec un dépôt d'alumine par imprégnation au moyen d'une barbotine, ou un dépôt de carbure de titane par dépôt chimique en phase vapeur.

Les documents EP-A-0 607 651 [2] et EP-A-0 608 081 [3] illustrent l'utilisation de revêtements à base d'oxydes métalliques, de fluorures métalliques ou de mélanges de ceux-ci, pour prévenir le dépôt de coke sur des surfaces en acier inoxydable.

Le document US-A-5,266,360 [4] illustre l'utilisation de revêtements à base de $SiO_2$, d'alumine ou de disulfure de tungstène, comprenant éventuellement des particules d'oxyde métallique telles que l'alumine, l'oxyde de cérium et l'oxyde cuprique pour inhiber la formation de coke sur des éléments de turbine à gaz.

Dans les documents [2] et [3], on réalise le dépôt par CVD alors que dans le document [4], les revêtements de $SiO_2$ sont obtenus par immersion dans une solution appropriée, par la technique sol-gel.

Ainsi, les revêtements les plus utilisés pour éviter ou limiter le dépôt de coke sur des surfaces métalliques sont à base d'oxyde, en particulier de $SiO_2$.

**Exposé de l'invention**

La présente invention a pour objet de nouveaux revêtements et un nouveau procédé pour prévenir le dépôt de coke sur une surface d'alliage réfractaire en contact avec des fluides hydrocarbonés.

Selon l'invention, le procédé pour prévenir le dépôt de coke sur une surface en alliage réfractaire en contact avec des fluides hydrocarbonés, comprend les étapes suivantes :

1)soumettre la surface en alliage réfractaire à l'action d'un plasma gazeux d'oxygène et/ou d'azote à basse fréquence, et

2)déposer sur la surface ainsi traitée un revêtement à base d'oxyde, de nitrure ou d'oxynitrure de silicium par dépôt chimique en phase vapeur assisté par plasma à basse fréquence, à partir d'un composé organosilicié et d'un gaz choisi parmi l'oxygène et l'azote,

les deux étapes étant réalisées consécutivement et en continu dans la même installation sans mise à l'air entre les deux étapes.

La première étape de ce procédé consiste à diffuser dans l'alliage réfractaire de l'oxygène et/ou de l'azote. Ce traitement de diffusion correspond soit à une nitruration, soit à une oxydation, soit une oxynitruration. Dans le cas d'une surface métallique en alliage réfractaire comportant du nickel et du fer, ce traitement permet de repousser les éléments facilitant le cokage comme le nickel et le fer, et de préparer ainsi la surface à recevoir un dépôt en favorisant de plus l'adhérence du dépôt qui sera formé ensuite dans la deuxième étape.

Selon l'invention, on réalise les deux étapes du procédé dans le même réacteur de dépôt chimique en phase vapeur assisté par plasma, qui comporte un système d'alimentation en les différents gaz utilisés tels que l'oxygène, l'azote, le composé organosilicié et éventuellement de l'argon.

Selon l'invention, on réalise chacune des étapes en utilisant une faible fréquence, par exemple une fréquence située dans la gamme de 2 à 450 kHz. Ainsi, on obtient une densité de plasma faible et des dépôts plus homogènes pouvant recouvrir des pièces de grandes dimensions.

Selon un mode préféré de réalisation de l'invention, on dépose dans la seconde étape un revêtement à base d'oxynitrure de silicium par PACVD.

Dans ce cas, on peut utiliser pour le dépôt par PACVD un composé organosilicié contenant de l'azote, par exemple l'hexaméthyldisilazane. Le mélange utilisé pour ce dépôt d'oxynitrure de silicium est un mélange du composé organosilicié azoté, par exemple d'hexaméthyldisilazane, et d'oxygène. De préférence, dans ce cas, on utilise dans la première étape un plasma gazeux d'oxygène pour oxyder la surface en alliage réfractaire.

Le revêtement obtenu dans ces conditions est un revêtement d'oxynitrure de silicium de formule $SiO_xN_y$ dans laquelle x et y sont tels que :

$$1 < x \leq 3$$

et

$$0,02 \leq y/x \leq 0,2.$$

Selon un second mode de réalisation de l'invention, on dépose dans la deuxième étape un revêtement à base de nitrure de silicium. Dans ce cas, on utilise dans cette deuxième étape un plasma formé à partir d'un mélange d'azote et d'un composé organosilicié contenant de l'azote comme l'hexaméthyldisilazane, et on effectue de préférence la première étape avec un plasma gazeux d'azote. Dans ce second mode de réalisation de l'invention, il est préférable de réaliser tout d'abord un décapage ionique de la surface en alliage réfractaire sous plasma d'argon avant d'effectuer les deux étapes du procédé de l'invention.

Dans ce second mode de réalisation de l'invention, on peut de plus effectuer une étape complémentaire d'oxydation du revêtement obtenu dans la seconde étape pour le convertir au moins en partie en oxynitrure de silicium.

Selon un troisième mode de réalisation du procédé de l'invention, on dépose dans la deuxième étape un revêtement à base d'oxyde de silicium, en utilisant un plasma formé à partir d'un mélange d'oxygène et d'un composé organosilicié contenant de l'oxygène tel que l'hexaméthyldisiloxane.

Dans ce cas, on utilise de préférence dans la première étape un plasma d'oxygène. Dans ce troisième mode de réalisation, on peut compléter les deux étapes du procédé par un troisième étape de traitement du revêtement obtenu par un plasma d'azote, afin de convertir en partie le revêtement de $SiO_x$ en oxynitrure de silicium.

Pour mettre en oeuvre les différentes étapes du procédé de l'invention, utilisant des plasmas gazeux, on opère dans la même installation de PACVD en utilisant des pressions très faibles, par exemple de 10 à 100 Pa.

Les durées sont choisies en fonction des débits gazeux de façon à obtenir des revêtements satisfaisants.

Dans la deuxième étape, la durée est de préférence telle que l'on obtienne un revêtement ayant une épaisseur de 0,1 à 100 μm.

Les débits gazeux sont dans la gamme de 10 à 500 cm$^3$/min.

En particulier, les rapports des débits d'oxygène ou d'azote sur le débit de composé organosilicié sont dans la gamme de 1 à 20.

Selon l'invention, l'alliage réfractaire soumis au traitement est un alliage réfractaire tel que ceux utilisés habituellement en pétrochimie. L'alliage peut être en particulier un alliage nickel-chrome-fer contenant 0,10 à 0,60% de carbone, 0,7 à 2% de manganèse et 1 à 2% de silicium, et éventuellement des additions mineures de niobium, titane, tungstène et zirconium.

A titre d'exemple, cet alliage peut être du type Manaurite en particulier une Manaurite tel que celles dont les compositions sont données dans le tableau 1 joint. Parmi celles-ci, on préfère les Manaurites XM et XTM ayant les compositions suivantes. La Manaurite XM comprenant :

- 33 à 38% de nickel,
- 23 à 28% de chrome,
- 0,35 à 0,60% de carbone,
- 1 à 1,5% de manganèse,
- 1 à 2% de silicium,

le reste étant du fer avec éventuellement des additions mineures de Nb, Ti et Zr.

La Manaurite XTM comprenant :

- 34 à 37% de chrome,
- 43 à 48% de nickel,
- 0,40 à 0,45% de carbone,
- 1 à 2% de manganèse,
- 1 à 2% de silicium,

le reste étant du fer avec éventuellement des additions mineures de Nb et Ti.

L'invention a également pour objet une pièce en alliage réfractaire comportant un revêtement d'oxynitrure de silicium de formule $SiO_xN_y$ dans laquelle x et y sont tels que :

$$1 < x \leq 3$$

et

$$0,02 \leq y/x \leq 0,2.$$

L'alliage réfractaire est en particulier un alliage nickel-chrome-fer, par exemple une Manaurite telle que celles décrites ci-dessus, et le revêtement peut avoir une épaisseur de 0,1 à 100 μm.

D'autres caractéristiques et avantages de l'invention apparaîtront mieux à la lecture de la description qui suit donnée bien entendu à titre illustratif et non limitatif, en référence au dessin annexé.

**Brève description du dessin**

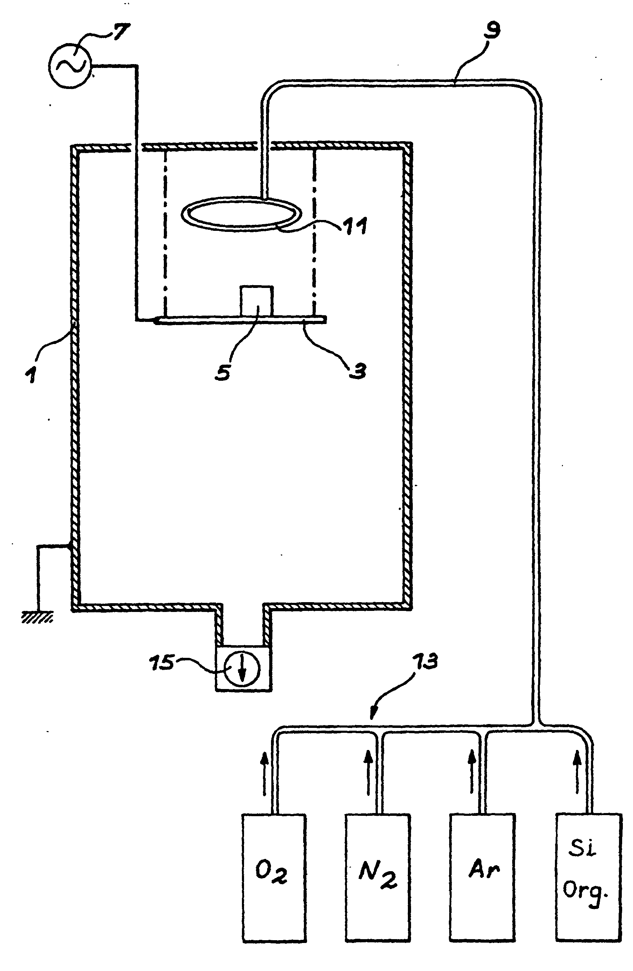

La figure 1 représente schématiquement en coupe verticale un réacteur convenant pour la mise en oeuvre du procédé de l'invention.

**Exposé détaillé des modes de réalisation**

Sur la figure 1, on voit que le réacteur de dépôt comprend une enceinte (1) mise à la terre, à l'intérieur de laquelle est disposé un support (3) pour les pièces à traiter (5), ce support étant relié à un générateur de basse fréquence (7). Le support (3) peut être un plateau ou une tige permettant de suspendre les pièces à traiter.

Le générateur (7) comprend un système de réglage de la puissance et de la fréquence ainsi qu'un dispositif d'affichage de la tension d'autopolarisation.

Les gaz nécessaires aux dépôts sont introduits dans l'enceinte par une conduite 9 reliée à un diffuseur de gaz 11 situé dans l'enceinte qui peut être cylindrique. La conduite 9 est relié à un système d'alimentation en gaz 13 qui comprend plusieurs lignes par lesquelles on peut amener au diffuseur de gaz 11, de l'oxygène, de l'azote, de l'argon, et le composé organique du silicium. L'enceinte est également reliée à une unité de pompage 15 à sa partie inférieure pour réaliser et maintenir la pression désirée dans l'enceinte.

Une console de contrôle, non représentée sur la figure, présente des dispositifs de commande de pompage, de débit de gaz, et de pression totale, la mesure de pression étant assurée par une jauge capacitive. Chaque ligne d'amenée de gaz est équipée d'un débitmètre massique à régulation électronique et d'une vanne d'arrêt qui sont reliés à l'armoire de commande munie de dispositifs d'affichage du débit et de réglage simultané.

Toutes les étapes du procédé de l'invention peuvent être mises en oeuvre dans ce réacteur.

Ainsi, après avoir introduit les pièces à traiter dans l'enceinte, on peut réaliser tout d'abord si nécessaire un traitement de décapage ionique à l'aide d'un plasma de gaz inerte, par exemple d'argon, en utilisant une pression suffisamment basse pour permettre un bombardement ionique puissant, par exemple une polarisation de -700 V.

On peut réaliser ensuite dans cette enceinte la première étape du procédé de l'invention au moyen d'un plasma d'oxygène ou d'azote, par exemple à une fréquence de 50 kHz. On procède ensuite au dépôt du revêtement à base de silicium, toujours dans la même enceinte, en modifiant les gaz introduits et les débits gazeux et en adaptant et en changeant la fréquence du plasma, si nécessaire.

Ainsi, la fréquence de fonctionnement peut être choisie pour chaque opération afin d'assurer le traitement ou la croissance du revêtement dans les meilleures conditions possibles afin d'obtenir les propriétés attendues et une bonne adhérence du revêtement.

Les exemples suivants donnés à titre indicatif et non limitatif, illustrent le procédé de l'invention.

Dans les exemples qui suivent, on utilise un substrat en Manaurite XM qui présente la composition donnée dans le tableau 1.

**Exemple 1**

Sur le substrat en Manaurite XM, on réalise un traitement d'oxydation ionique à l'aide d'un plasma d'oxygène pur, à une pression de travail de l'ordre de 16 Pa (0,16 mbar) avec un débit d'oxygène de 50 $cm^3$/min et une fréquence de 50 kHz. On réalise ce traitement pendant 30 minutes.

Ensuite, on forme sur le substrat un revêtement à base d'oxyde de silicium au moyen d'un plasma d'oxygène et d'hexaméthyldisiloxane avec des débits respectifs de 250 $cm^3$/min pour l'oxygène et de 25 $cm^3$/min pour l'hexaméthyldisiloxane. On opère sous une pression de 50 Pa (0,5 mbar), à une fréquence de 50 kHz, pendant 40 minutes.

On obtient ainsi un revêtement à base d'oxyde de silicium de 1 μm d'épaisseur.

On teste le comportement au cokage du substrat en Manaurite ainsi revêtu en le mettant en contact avec un flux d'hydrocarbure (Naphta) à une température de 810°C pendant 20 min. A titre comparatif, on effectue le même essai sur un substrat en Manaurite XM non traité.

L'amélioration du comportement au cokage du substrat revêtu par rapport au substrat non revêtu est de 6 à 10%.

**Exemple 2**

Dans cet exemple, on utilise un substrat en Manaurite identique à celui de l'exemple 1 et on réalise tout d'abord sur celui-ci un traitement de décapage ionique sous plasma d'argon pendant 1 heure en utilisant un débit d'argon de 50 $cm^3$/min, une pression de 10 Pa (0,1 mbar) et une fréquence de 50 kHz.

Après ce traitement, on soumet le substrat à l'action d'un plasma d'azote pendant 30 minutes sous une pression totale de 30 Pa (0,3 mbar), en opérant à une fréquence de 50 kHz avec un débit d'azote de 50 $cm^3$/min

On dépose ensuite un revêtement à base de nitrure de silicium à partir d'un plasma formé d'un mélange gazeux azote-hexaméthyldisilazane, avec des débits respectifs de 100 $cm^3$/min pour l'azote et de 10 $cm^3$/min pour l'hexaméthyldisilazane sous une pression de 30 Pa, à une fréquence de 50 kHz, pendant 45 minutes.

Après cette étape de formation du revêtement, on soumet le substrat à une oxydation sous air pendant 1 heure à 1000°C.

On obtient ainsi un revêtement à base de d'oxynitrure de silicium de 2 μm d'épaisseur.

On soumet le substrat ainsi traité au même essai de comportement au cokage que dans l'exemple 1. On constate ainsi qu'il présente une amélioration du comportement au cokage de 9 à 10% par rapport au substrat de Manaurite non revêtu.

### Exemple 3

Dans cet exemple, on forme sur un substrat en Manaurite identique à celui de l'exemple 1, un revêtement à base d'oxynitrure de silicium.

Dans ce but, on soumet tout d'abord le substrat à un traitement d'oxydation ionique à l'aide d'un plasma d'oxygène pur à une pression de travail de l'ordre de 16 Pa (0,16 mbar), sous une fréquence de 50 kHz avec un débit d'oxygène de 50 $cm^3$/min pendant 30 minutes.

On réalise ensuite le dépôt par PACVD en utilisant un mélange d'oxygène et d'hexaméthyldisiloxane avec des débits respectifs de 100 $cm^3$/min pour l'oxygène et de 10. $cm^3$/min pour l'hexaméthyldisiloxane, sous une pression de 50 Pa (0,5 mbar), à une fréquence de 50 kHz, pendant 40 minutes.

Après la formation de ce revêtement, on effectue un post-traitement dans la même enceinte au moyen d'un plasma d'azote en utilisant un débit d'azote de 100 $cm^3$/min, une pression de travail de l'ordre de 30 Pa et une fréquence de 50 kHz, pendant 30 minutes.

On soumet le substrat ainsi traité au même essai de comportement au cokage que dans l'exemple 1, on remarque ainsi qu'il présente une amélioration du comportement au cokage de 16 à 21% par rapport au substrat non revêtu en Manaurite XM.

### Exemple 4

Dans cet exemple, on soumet un substrat en Manaurite identique à celui de l'exemple 1 à un traitement d'oxydation ionique au moyen d'un plasma d'oxygène pur, en utilisant un débit d'oxygène de 50 $cm^3$/min, une pression de travail de l'ordre de 16 Pa (0,16 mbar) et une fréquence de 50 kHz, pendant 30 minutes.

Après ce traitement, on dépose un revêtement d'oxynitrure de silicium par PACVD en utilisant un mélange oxygène-hexaméthyldisilazane avec des débits respectifs de 24 $cm^3$/min pour l'oxygène et de 12 $cm^3$/min pour l'hexaméthyldisilazane, sous une pression de 50 Pa (0,5 mbar), une fréquence de 50 kHz, pendant 40 minutes.

On soumet le produit obtenu au même essai de comportement au cokage que dans l'exemple 1. L'amélioration obtenue est de 39 à 54% par rapport au substrat en Manaurite XM non revêtu.

### Exemple 5

Dans des conditions similaires à celles de l'exemple 4, on effectue le revêtement de tubes en Manaurite XM de 70 cm de longueur et d'un diamètre de 4 cm.

On soumet ensuite ces tubes à un essai de comportement au cokage à 810°C, et on observe une amélioration très importante du comportement au cokage du tube revêtu par rapport au tube non revêtu, cette amélioration étant de l'ordre de 40%.

On teste ensuite des conditions extrêmes du four de cokage, soit une température de 980°C, et on obtient encore dans ces conditions une amélioration de l'ordre de 20%.

On effectue enfin un troisième essai sur les mêmes tubes à une température de 810°C et l'on constate que le revêtement se comporte toujours de façon efficace puisque l'amélioration obtenue est encore de 50 à 53%.

### Références citées

[1] FR-A-2 662 704
[2] EP-A-0 607 651
[3] EP-A-0 608 081
[4] US-A-5,266,360

Tableau 1

| Alliage réfractaire | Désignation Thermalloy (T) | Composition % | | | | | | Additions éventuelles |
|---|---|---|---|---|---|---|---|---|
| | | C | Mn | Si | Ni | Cr | Fe | |
| Manaurite 36X | T-64 | 0,35/0,60 | 1,00/1,50 | 1,00/2,00 | 33/38 | 23/28 | le reste | Nb |
| | TX-63 | 0,35/0,50 | 1,00/1,50 | 1,00/2,00 | 33/38 | 23/28 | le reste | Ti, W |
| Manaurite XM | MA-6300 | 0,35/0,60 | 1,00/1,50 | 1,00/2,00 | 33/38 | 23/28 | le reste | Nb, Ti, Zr |
| Manaurite 36XS | | 0,35/0,60 | 0,70/1,25 | 1,00/2,00 | 33/38 | 21/28 | le reste | W+Nb |
| Manaurite 35-25W | T-63W | 0,35/0,60 | 0,70/1,25 | 1,00/2,00 | 33/38 | 21/28 | le reste | W |
| Manaurite XA | | 0,35/0,50 | 1,00/2,00 | 1,00/2,00 | 34/40 | 20/27 | le reste | Nb |
| | T-58 | 0,40/0,60 | 0,70/1,25 | 1,00/2,00 | 37/40 | 18/21 | le reste | Nb |
| Manaurite XT | | 0,35/0,45 | 1,00/1,50 | 1,00/2,00 | 42/46 | 32/37 | le reste | Nb |
| Manaurite XTM | | 0,40/0,45 | 1,00/2,00 | 1,00/2,00 | 43/48 | 34/37 | le reste | Nb, Ti |
| Manaurite 24/24 Nb | T-45 | 0,35/0,50 | 1,00/1,50 | 1,00/2,00 | 23,5/26,5 | 19/26,5 | le reste | Nb |
| Manaurite 900 | T-53 | 0,06/0,15 | 1,00/1,50 | 0,75/1,50 | 29/37 | 16/22 | le reste | Nb |
| Manaurite 900B | TX-53 | 0,10/0,18 | 1,00/1,50 | 1,00/1,50 | 33/37 | 24/27 | le reste | Nb |
| Manurite 35 | T-50 | 0,25/0,60 | 1,00/1,50 | 1,00/2,00 | 30/38 | 14/23 | le reste | Nb. Ti et W |

**Revendications**

1. Procédé pour prévenir le dépôt de coke sur une surface en alliage réfractaire, en contact avec des fluides hydrocarbonés, qui comprend les étapes suivantes :

   1) soumettre la surface en alliage réfractaire à l'action d'un plasma gazeux d'oxygène et/ou d'azote à basse fréquence, et
   2) déposer sur la surface ainsi traitée un revêtement à base d'oxyde, de nitrure ou d'oxynitrure de silicium par dépôt chimique en phase vapeur assisté par plasma à basse fréquence, à partir d'un composé organosilicié et d'un gaz choisi parmi l'oxygène et l'azote,

   les deux étapes étant réalisées consécutivement et en continu dans la même installation sans mise à l'air entre les deux étapes.

2. Procédé selon la revendication 1, dans lequel on réalise chacune des étapes à une fréquence de 2 à 450 kHz.

3. Procédé selon la revendication 1 ou 2, dans lequel le composé organosilicié est l'hexaméthyldisilazane.

4. Procédé selon la revendication 3, dans lequel on utilise dans la première étape un plasma d'oxygène et dans la seconde étape un plasma formé à partir d'oxygène et d'hexaméthyldisilazane.

5. Procédé selon la revendication 3, dans lequel on utilise dans la première étape un plasma d'azote et dans la seconde étape un plasma formé à partir d'un mélange d'azote et d'hexaméthyldisilazane.

6. Procédé selon la revendication 5, dans lequel on effectue tout d'abord un traitement de décapage ionique sous plasma d'argon de la surface en alliage réfractaire avant de réaliser les deux étapes du procédé.

7. Procédé selon la revendication 5 ou 6, dans lequel on réalise une étape complémentaire d'oxydation du revêtement obtenu dans la seconde étape.

8. Procédé selon la revendication 1 ou 2, dans lequel le composé organosilicié est l'hexaméthyldisiloxane.

9. Procédé selon la revendication 8, dans lequel on utilise dans la première étape un plasma d'oxygène et dans la deuxième étape un plasma formé à partir d'un mélange d'oxygène et d'hexaméthyldisiloxane.

10. Procédé selon la revendication 9, qui comprend en outre une étape complémentaire de traitement du revêtement obtenu dans la seconde étape, dans un plasma d'azote.

11. Procédé selon l'une quelconque des revendications 1 à 10, dans lequel la durée de la seconde étape est telle que l'on forme un revêtement d'une épaisseur de 0,1 à 100 μm.

12. Procédé selon l'une quelconque des revendications quelconques 1 à 11, dans lequel l'alliage réfractaire est un alliage nickel-chrome-fer contenant 0,10 à 0,60% de carbone, 0,7 à 2% de manganèse et 1 à 2% de silicium.

13. Procédé selon la revendication 12, dans lequel l'alliage nickel-chrome-fer a la composition suivante :

   - 33 à 38% de nickel,
   - 23 à 28% de chrome,
   - 0,35 à 0,60% de carbone,
   - 1 à 1,5% de manganèse,
   - 1 à 2% de silicium,

   le reste étant constitué essentiellement par du fer, avec éventuellement des additions mineures de Nb, Ti et/ou Zr.

14. Procédé selon la revendication 12, dans lequel l'alliage nickel-chrome-fer comprend :

   - 34 à 37% de chrome,
   - 43 à 48% de nickel,

- 0,40 à 0,45% de carbone,
- 1 à 2% de manganèse,
- 1 à 2% de silicium,

le reste étant constitué par du fer et éventuellement des additions mineures de niobium et/ou titane.

15. Pièce en alliage réfractaire comportant un revêtement d'oxynitrure de silicium de formule $SiO_xN_y$ dans laquelle x et y sont tels que :

$$1<x\leq3$$

et

$$0,02\leq y/x\leq0,2.$$

16. Pièce selon la revendication 15, dans laquelle l'alliage réfractaire est un alliage nickel-chrome-fer.

17. Pièce selon la revendication 16, dans laquelle l'alliage nickel-chrome-fer comprend :

- 33 à 38% de nickel,
- 23 à 28% de chrome,
- 0,35 à 0,60% de carbone,
- 1 à 1,5% de manganèse,
- 1 à 2% de silicium,

le reste étant constitué essentiellement par du fer, avec éventuellement des additions mineures de Nb, Ti et/ou Zr.

18. Pièce selon la revendication 16, dans laquelle l'alliage nickel-chrome-fer comprend :

- 34 à 37% de chrome,
- 43 à 48% de nickel,
- 0,40 à 0,45% de carbone,
- 1 à 2% de manganèse,
- 1 à 2% de silicium,

le reste étant constitué par du fer et éventuellement des additions mineures de niobium et/ou titane.

19. Pièce selon l'une quelconque des revendications 15 à 18, dans laquelle le revêtement a une épaisseur de 0,1 à 100 µm.


**Patentansprüche**

1. Verfahren zur Verhinderung der Ablagerung von Koks auf der Oberfläche einer feuerfesten Legierung, welche sich in Kontakt mit Flüssigkeiten befindet, die Kohlenwasserstoff enthalten, umfassend die folgenden Schritte:

1) Unterwerfen der Oberfläche der feuerfesten Legierung einer Wirkung eines gasförmigen Sauerstoff- und/oder Stickstoffplasmas bei niedriger Frequenz und

2) Abscheiden einer Beschichtung auf der Basis von Siliziumoxid, -nitrid oder -oxynitrid durch Plasma unterstütztes chemisches Dampfabscheiden bei niedriger Frequenz auf der so behandelten Oberfläche, unter Verwendung einer Organosiliziumverbindung und einem Gas, gewählt aus Sauerstoff und Stickstoff,

wobei die beiden Schritte aufeinander folgenden und kontinuierlich in der gleichen Einrichtung durchgeführt werden, ohne diese zwischen den zwei Schritten der Atmosphäre zu öffnen.

**2.** Verfahren nach Anspruch 1, wobei jeder der Schritte bei einer Frequenz von 2 bis 450 kHz durchgeführt wird.

**3.** Verfahren nach Anspruch 1 oder 2, wobei die Organosiliziumverbindung Hexamethyldisilazan ist.

**4.** Verfahren gemäß Anspruch 3, wobei in dem ersten Schritt ein Sauerstoffplasma verwendet wird und in dem zweiten Schritt ein Plasma, gebildet aus Sauerstoff und Hexamethyldisilazan.

**5.** Verfahren nach Anspruch 3, wobei in dem ersten Schritt ein Stickstoffplasma verwendet wird und in dem zweiten Schritt ein Plasma verwendet wird, gebildet aus einer Mischung aus Stickstoff und Hexamethyldisilazan.

**6.** Verfahren nach Anspruch 5, wobei zunächst ein Ionenbeizverfahren an der Oberfläche der feuerfesten Legierung in Argonplasma durchgeführt wird, bevor die zwei Schritte des Verfahrens durchgeführt werden.

**7.** Verfahren nach Anspruch 5 oder 6, wobei ein zusätzlicher Schritt der Oxidation der in dem zweiten Schritt erhaltenen Beschichtung durchgeführt wird.

**8.** Verfahren nach Anspruch 1 oder 2, wobei die Organosiliziumverbindung Hexamethyldisiloxan ist.

**9.** Verfahren nach Anspruch 8, wobei in dem ersten Schritt ein Sauerstoffplasma verwendet wird und in dem zweiten Schritt ein Plasma verwendet wird, aus einer Mischung aus Sauerstoff und Hexamethyldisiloxan.

**10.** Verfahren nach Anspruch 9, auch umfassend einen zusätzlichen Schritt der Behandlung der Beschichtung, welche in dem zweiten Schritt erhalten wurde, in einem Stickstoffplasma.

**11.** Verfahren nach einem der Ansprüche 1 bis 10, wobei die Dauer des zweiten Schritts solchermaßen ist, dass eine Beschichtung mit einer Dicke von 0,1 bis 100 $\mu$m gebildet wird.

**12.** Verfahren nach einem der Ansprüche 1 bis 11, wobei die feuerfeste Legierung eine Nickel-Chrom-Eisenlegierung ist, enthaltend 0,10 bis 0,60 % Kohlenstoff, 0,7 bis 2 % Mangan und 1 bis 2 % Silizium.

**13.** Verfahren nach Anspruch 12, wobei die Nickel-Chrom-Eisenlegierung die folgende Zusammensetzung aufweist:

33 bis 38 % Nickel,
23 bis 28 % Chrom,
0,35 bis 0,60 % Kohlenstoff,
1 bis 1,5 % Mangan,
1 bis 2 % Silizium,

wobei der Rest im Wesentlichen aus Eisen besteht, mit möglichen kleinen Zugaben an Nb, Ti und/oder Zr.

**14.** Verfahren nach Anspruch 12, wobei die Nickel-Chrom-Eisenlegierung umfasst:

34 bis 37 % Chrom,
43 bis 48 % Nickel,
0,40 bis 0,45 % Kohlenstoff,
1 bis 2 % Mangan,
1 bis 2 % Silizium,

wobei der Rest aus Eisen und möglichen kleineren Zugaben an Niob und/oder Titan besteht.

**15.** Bauteil aus einer feuerfesten Legierung mit einer Beschichtung aus Siliziumoxinitrid der Formel $SiO_xN_y$, wobei x und y solchermaßen sind, dass

$$1 < x \leq 3$$

und

$$0,025 \leq y/x \leq 0,2.$$

**16.** Bauteil gemäß Anspruch 15, wobei die feuerfeste Legierung eine Nickel-Chrom-Eisenlegierung ist.

**17.** Bauteil gemäß Anspruch 16, wobei die Nickel-Chrom-Eisenlegierung umfasst:

33 bis 38 % Nickel,
23 bis 28 % Chrom,
0,35 bis 0,60 % Kohlenstoff,
1 bis 1,5 % Mangan,
1 bis 2 % Silizium,

wobei der Rest im Wesentlichen aus Eisen besteht, mit möglichen kleinen Zugaben an Nb, Ti und/oder Zr.

**18.** Bauteil nach Anspruch 16, wobei die Nickel-Chrom-Eisenlegierung umfasst:

34 bis 37 % Chrom,
43 bis 48 % Nickel,
0,40 bis 0,45 % Kohlenstoff,
1 bis 2 % Mangan,
1 bis 2 % Silizium,

wobei de Rest aus Eisen und möglichen kleineren Zugaben an Niob und/oder Titan besteht.

**19.** Bauteil gemäß einem der Ansprüche 15 bis 18, wobei die Umhüllung eine Dicke von 0,1 bis 100 µm aufweist.


**Claims**

**1.** A method for preventing the deposition of coke on a refractory alloy surface in contact with fluids containing hydrocarbons, which comprises the following steps:

1) subjecting the refractory alloy surface to the action of a gaseous plasma of oxygen and/or nitrogen at low frequency, and
2) depositing on the surface thus treated a coating based on silicon oxide, nitride or oxynitride by plasma assisted chemical vapour deposition at low frequency, using an organosilicic compound and a gas chosen from amongst oxygen and nitrogen,

the two steps being carried out consecutively and continuously in the same installation without opening to atmosphere between the two steps.

**2.** A method according to Claim 1, in which each of the steps is performed at a frequency of 2 to 450 kHz.

**3.** A method according to Claim 1 or 2, in which the organosilicic compound is hexamethyldisilazane.

**4.** A method according to Claim 3, in which in the first step an oxygen plasma is used and in the second step a plasma formed from oxygen and hexamethyldisilazane.

**5.** A method according to Claim 3, in which in the first step a nitrogen plasma is used and in the second step a plasma formed from a mixture of nitrogen and hexamethyldisilazane.

**6.** A method according to Claim 5, in which first of all an ionic pickling treatment of the refractory alloy surface is carried out under argon plasma before performing the two steps of the method.

**7.** A method according to Claim 5 or 6, in which a supplementary step of oxidation of the coating obtained in the second step is performed.

**8.** A method according to Claim 1 or 2, in which the organosilicic compound is hexamethyldisiloxane.

**9.** A method according to Claim 8, in which in the first step an oxygen plasma is used and in the second step a plasma from a mixture of oxygen and hexamethyldisiloxane.

**10.** A method according to Claim 9, which also comprises a supplementary step of treating the coating obtained in the second step, in a nitrogen plasma.

**11.** A method according to any one of Claims 1 to 10, in which the duration of the second step is such that a coating is formed with a thickness of 0.1 to 100 μm.

**12.** A method according to any one of Claims 1 to 11, in which the refractory alloy is a nickel-chromium-iron alloy containing 0.10 to 0.60% carbon, 0.7 to 2% manganese and 1 to 2% silicon.

**13.** A method according to Claim 12, in which the nickel-chromium-iron alloy has the following composition:

- 33 to 38% nickel,
- 23 to 28% chromium,
- 0.35 to 0.60% carbon,
- 1 to 1.5% manganese,
- 1 to 2% silicon,

the remainder consisting essentially of iron, with possibly minor additions of Nb, Ti and/or Zr.

**14.** A method according to Claim 12, in which the nickel-chromium-iron alloy comprises:

- 34 to 37% chromium,
- 43 to 48% nickel,
- 0.40 to 0.45% carbon,
- 1 to 2% manganese,
- 1 to 2% silicon,

the remainder consisting of iron and possibly minor additions of niobium and/or titanium.

**15.** A refractory alloy part having a coating of silicon oxynitride of formula $SiO_xN_y$ in which x and y are such that:

$$1 < x \leq 3$$

and

$$0.02 \leq y/x \leq 0.2.$$

**16.** A part according to Claim 15, in which the refractory alloy is a nickel-chromium-iron alloy.

**17.** A part according to Claim 16, in which the nickel-chromium-iron alloy comprises:

- 33 to 38% nickel,
- 23 to 28% chromium,
- 0.35 to 0.60% carbon,
- 1 to 1.5% manganese,
- 1 to 2% silicon, the remainder consisting essentially of iron, with possibly minor additions of Nb, Ti and/or Zr.

**18.** A part according to Claim 16, in which the nickel-chromium-iron alloy comprises:

- 34 to 37% chromium,
- 43 to 48% nickel,

- 0.40 to 0.45% carbon,
- 1 to 2% manganese,
- 1 to 2% silicon,

the remainder consisting of iron and possibly minor additions of niobium and/or titanium.

**19.** A part according to any one of Claims 15 to 18, in which the cladding has a thickness of 0.1 to 100 μm.